# EUROPEAN PATENT SPECIFICATION

(11) **EP 2 013 971 B1**
(45) Date of publication and mention of the grant of the patent: **22.05.2019**
(21) Application number: 07747403.9
(22) Date of filing: 25.04.2007
(51) Int. Cl.: H03K 17/96, G06F 3/041

(54) **SWITCH UNIT COMPRISING A TOUCH PANEL BEING PART OF A FRONT PLATE EXTENDING OVER A FULL FACE OF A DEVICE AND CORRESPONDING DEVICE**
SCHALTEINHEIT MIT EINER BERÜHRUNGSTAFEL, DIE TEIL EINER FRONTPLATTE IST, DIE SICH ÜBER EINE VOLLSEITE EINER EINRICHTUNG ERSTRECKT, UND ENTSPRECHENDE EINRICHTUNG
ELEMENT COMMUTATEUR COMPRENANT UN PANNEAU TACTILE INTEGRE A UNE PLAQUE FRONTALE RECOUVRANT UNE FACE COMPLETE D'UN DISPOSITIF ET DISPOSITIF CORRESPONDANT

(30) Priority: 25.04.2006 FI 20060396
(43) Date of publication of application: 14.01.2009
(73) Proprietor: Aito B.V., 1506 GC Zaandam (NL)
(72) Inventor: LÖNNBERG, Jockum, 1521 NE Wormerveer (NL); RUOHONEN, Simo, 1521 NE Wormerveer (NL); LÖYTTY, Matti, 1521 NE Wormerveer (NL); LÖNNQVIST, Christian, 1521 NE Wormerveer (NL); HIRVONEN, Annika, 1521 NE Wormerveer (NL); HÖRHAMMER, Johan, 1521 NE Wormerveer (NL); KURKI, Tommi, 1521 NE Wormerveer (NL); SYDÄNHEIMO, Henri, 1521 NE Wormerveer (NL); TANHUA, Sakari, 1521 NE Wormerveer (NL); PERALES, Carlos Fernando Onofre, 1521 NE Wormerveer (NL); DE LA CRUZ, Javier, 1521 NE Wormerveer (NL)
(74) Representative: Papula Oy
(86) International application number: PCT/NL2007/050179
(87) International publication number: WO 2007/123404

(56) References cited:
- EP-A1- 0 210 386
- EP-A1- 0 366 832
- EP-A1- 0 512 124
- EP-A1- 0 512 124
- WO-A-99/35745
- WO-A-2005/059935
- DE-C1- 3 904 702
- US-A- 5 479 528
- US-A1- 2003 214 485
- US-A1- 2004 131 996

## Description

The invention relates to a switch unit comprising a substantially flat front plate with an actuation area, a structure located behind the front plate, at least two pressure sensitive transducers located in the structure adjacent to the actuation area, the transducers being adapted to convert pressure exerted by the front plate to said at least one transducer into electrical signals and a processing unit adapted to process the signals from said at least two transducers and to determine whether the actuation area of the front plate was actuated.

Switch units of this type according to the prior art have front plates which extend over only a limited part of the face of the device of which the switch unit forms a part. This leads to a seam between the front plate and the cover and other structure which covers the rest of said face of the device. This seam may easily get soiled especially when the device is used in dirty surroundings. This is also a problem when the device is used in surroundings requiring a high hygienic standard, like in the food processing industry, in kitchens or in restaurants.

To avoid these problems the present invention provides the feature that the front plate extends over a larger area than the area covered by the transducers.

An operator control comprising sensor elements made of a special plastic material that produces an electric signal in response to compression reducing the volume of the plastic material is disclosed in international patent application published under publication number WO 2005/059935 A2.

A keyboard comprising piezo elements placed in special drillings made in a circuit board is disclosed in European patent application published under publication number EP 0 512 124 A1.

A further keyboard comprising piezo elements placed between two foils is disclosed in European patent application published under publication number EP 0 210 386 A1.

This feature provides not only a cover without any seams, offering better cleanliness and hygienic circumstances, but also the possibility to make the device waterproof without much extra efforts.

The invention also provides a device comprising a switch unit referred to above.

It is an objective to provide a switch unit comprising a touch panel being part of a front plate extending over a full face of a device and corresponding device. The objective is achieved by the features of the independent claim. Some embodiments are described in the dependent claims.

A first embodiment provides the feature that the front plate is dimensioned to extend over a full face surface of a device of which the switch unit forms a part. This embodiment simply provides a feature wherein the switch unit takes only a part of the face surface of the device. Another embodiment provides the feature that the processing unit is adapted to determine the location within the actuation area where the front panel was actuated. This allows the number of transducers to be limited, for instance when the front plate has been marked to encompass a range and at each end of the range a transducer has been provided. The person making a choice within the range presses an according location of the marking representing the range so that the two transducers are actuated proportionally. The processing unit processes the proportional signals to determine where the marking representing the range has been pressed and to supply an according signal. This system also works in a two dimensional structure, requiring however more than two transducers.

Yet another preferred embodiment provides the feature that the front plate at the location of the actuation area is transparent and that a display device has been located behind the transparent area. This embodiment provides a so called touch panel, fit for numerous applications. The versatility of this embodiment is enhanced when the image displayed by the display forms an indication for the function to be controlled by actuating a part of the front plate.

For simpler functions it will suffice to use a light source instead of a complete display. Then it is preferable if the front plate at the location of the actuation area is transparent to at least some extend and that a light emitting device has been located behind said transparent area.

Switch units of the kind referred to above require flexing of the front plate, if only to a limited extend. To allow an easier flexing of the front plate, it is preferred that the structure comprises a connection element extending along the circumference of the front plate and forming a connection between the front plate and a rigid part of the structure, wherein the connection element is adapted to allow flexing of the front plate with a minimal force. This in particular but not exclusively the case for switch units wherein the transducers are located around an actuation area and wherein the processing unit is adapted to determine where within the actuation area the front plate has been actuated. Besides this low force is achieved by making the making the connection element such that it can only transmit a limited momentum. A preferred embodiment provides the feature that a weakening extends around the outer circumference of the combination of the actuation area and the transducers arranged around it. These features allow an easy flexing of the front plate at the weakening so that the weakening functions as a kind of hinge. In the area enclosed by the weakening the front plate is more rigid so that the forces observed by the transducers allow an easy reconstruction of the location within the actuation area where the actuation area was pressed.

To maintain a smooth easily cleanable outer surface of the front plate, the weaking takes the shape of a groove extending along the underside of the front plate.

The embodiment provides in a front plate which covers more than the area taken by the switch unit itself. In some applications it may be wise to provide an extra cover plate on the front plate, for instance when the appearance of the usually plastic front plate is not suitable for the specific application or when the it is not rugged enough to make it vandal proof. Of course care should be taken to leave the surface of the switch unit and if applicable that of the display unit free.

Yet another embodiment provides the feature that the front plate also comprises at least one second actuation area, being transparent and that a light emitting device has been located behind said transparent area, allowing the possibility to construct aggregate panels with different functions of control.

According to a preferred embodiment at least some of the transducers and preferably all transducers are piezo-electric transducers and that the structure comprises a switch layer extending parallel to the front plate, wherein a number of apertures has been provided being at least equal to the number of transducers and wherein each of the transducers is located in one of the apertures provided in said switch layer. It has appeared that this particular type of transducers is suitable for this type of switch, as it has a long expected life time so that the complete switch unit may be sealed off without problems for accessibility of the transducers. This sealing is another feature in the suitability of the switch unit for soiling sensitive surroundings. Herein its is noted than under the expression piezo-electric transducers not only transducers are to be understood which are adapted to generate a voltage when they are flexed but also piezo-resistive transducers and piezo-capacitive transducers. Further this construction allows an easy positioning of the transducers during production.

Piezo-electric transducers generate voltages when a pressure is applied to them or when they are flexed. The construction of the structure in which they are located must thus be adapted to allow flexing of the transducers, when the force is applied to the front plate. A first possibility to allow this is to provide an aperture between the connection layer furthest from the front plate at the locations of each of the switches. Herein a distance block is provided between the front plate and transducer so that the movement of the front plate is transferred to the transducer and the transducer itself may flex downward as the aperture is present under the transducer. Of course care should be taken that the rims of the transducer are fixed, so that the centre of the transducer can be moved relative to the rims and flexing develops.

Another possibility of allowing flexing of the transducer is that to provide an aperture between the connection layer closest to the front plate at the locations of each of the transducers. Herein - contrary to the embodiment according to the preceding claim - the centre of the transducer is fixed, while its centre can be pressed downward. This is achieved by the aperture which prevents that the force exerted by the front plate is transferred to the centre of the transducer, rather this force is only transmitted to the rims of the transducer. Of course also in this embodiment the layer of the structure under the transducer is adapted to allow flexing by provision of a central distance block which is surrounded by a open space.

Preferably the structure comprises two connection layers located at either side of the switch layer, wherein the connection layers are each composed of a foil comprising conducting tracks connecting each of the transducers to the processing unit. This provides an easy way of providing connections between the transducers an the processing unit. To allow the flexing of the piezo electric elements, the connection layers should be thin as well, as they should flex together with the transducers themselves.

The embodiment refers to two different kind of switch units, that is switch units wherein two transducers are located on either side of the actuation area on the front plate, and wherein a light emitting device is located under the actuation area and touch panels like configurations wherein the a number of transducers is located on sides of the actuation area under which a display unit is located. The embodiment also relates to combinations of switch unit referred to above and to combinations of these switch units with normal simple switch units known from the prior art wherein the transducer is located directly under the actuation area on the front plate. This enhances the versatility of the combined switch unit. This is in particular true for the control of electrical apparatus, like an oven wherein a direct switch is adapted to control the on/off function of the power supply, and another switch is adapted to another main function, like the choice between the micro wave and the hot air function of the oven and wherein a touch panel is adapted to control the temperature of the oven.

### List of drawings

Subsequently, the present invention will be elucidated with the help of the following drawings, of which:
- FIG 1: shows a cross sectional view of a switch unit according to a first embodiment;
- FIG 2: shows a cross sectional view of a switch unit according to a second embodiment;
- FIG 3: shows a cross sectional view of a switch unit according to a third embodiment; and
- FIG 4: shows a cross sectional view of a switch unit according to a fourth embodiment.

### Detailed description

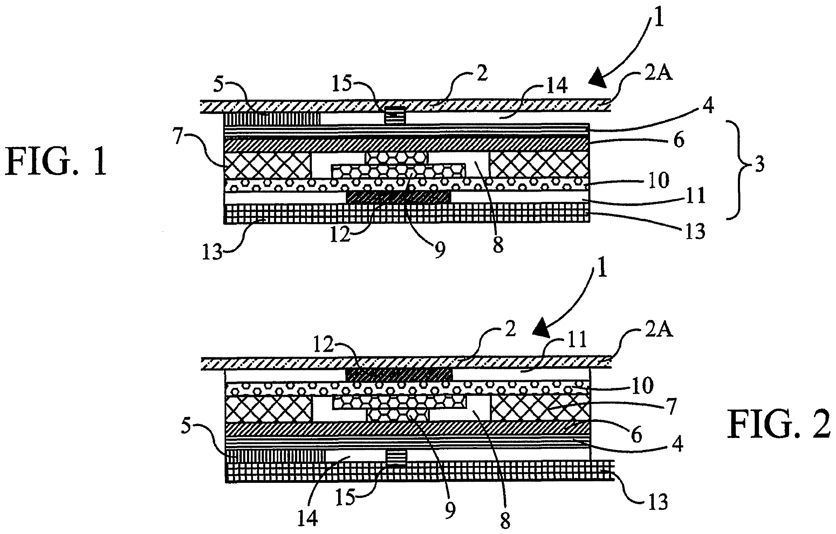

FIG 1 shows a switch unit 1, comprising a front plate 2 and a structure 3. It appears from FIG 1 that the front plate 2 extends beyond the structure 3. The front plate 2 is preferably made of a transparent plastic material like polycarbonate or acrylate.

The structure 3 comprises an intermediate layer 4 having a thickness of about 1 mm. In this intermediate layer 4 apertures 14 have been provided above the locations of the piezoelectric elements 9 and extending towards the actuation area 2a. However, to transfer the pressure exerted by the pressing on the front plate 2, a distance block 15 has been provided in the aperture 14. Again, this intermediate layer 4 is preferably made of a plastic material. It is adhered to the front plate 2 by a glue layer 5. Under the intermediate layer 4, a first connection layer 6 has been located, again preferably through adherence with the intermediate layer 4.

The connection layer 6 is preferably made of electrically insulating material, on which conducting tracks have been printed for connecting the processing unit, which is not depicted in the drawings, with the piezoelectric elements 9. This first connection layer 6 is flexible.

Under the first connection layer 6 the transducer layer 7 has been provided. This transducer layer 7 is provided with apertures 8 offering space for the piezoelectric elements 9.

Under the transducer layer 7 a second connection layer 10 has been located, again preferably through adherence with the transducer layer 7. The second connection layer 10 is again preferably made of electrically insulating material, on which conducting tracks have been printed for connecting the processing unit with the piezoelectric elements. This second connection layer 10 is flexible.

Under the second connection layer 10 a spacer layer 11 has been provided, which comprises apertures 12 under the piezoelectric elements 7, but having a smaller size than the piezoelectric elements. These apertures allow flexing of the piezoelectric elements.

The lowest layer is the baseplate 13, preferably made of rigid material, that is more rigid than the front plate 2. This plate may also be made from plastic material, or a metal like aluminium.

When the front plate 2 is pressed at the actuation area 2a, the movement is transferred to the intermediate layer 4 by the distance block 15 and further to the piezoelectric element 9 which flexes under the central pressure with its rims fixed so that the piezoelectric element 9 generates a voltage which is conducted to the processing unit through the tracks on the first and the second connection layer 6, 10, respectively.

This embodiment requires a connection between the front plate 2 and the distance block 15 to avoid a relocation of the distance block 15 within the aperture 14. This may be less favorable when the underside of the front plate 2 has to be printed as is often the case.

To avoid this, the second embodiment shown in to FIG 2 has been devised. The structure 3 of the switch unit 1 shown in FIG 2 is the opposite of the structure 3 according to FIG 1. The structure 3 comprises from the front layer 1 downwards: The spacer layer 11 with the apertures 12, the second connection layer 10, the transducer layer 7 with the apertures 8 and the piezoelectric elements 9 therein, the first connection layer 6, the intermediate layer 4, the glue layer 5 with the apertures 14 provided therein and the base layer 13.

The functioning of this switch unit 1 is similar to that of the switch unit 1 shown in FIG 1 in that the pressure exerted on the front panel 2 is transferred to the outer rim of the piezoelectric element 9 by the spacer layer 11 and the second connection layer 10, while downward movement of the other layers is allowed at the location of the apertures 12, 14. Herein the glue layer 14 avoids a further downward movement of the centre of the piezoelectric element 9 if a pressure is not applied above the apertures 12, 14.

Both embodiments allow an extension of the front plate 2 to beyond the actual piezoelectric elements 9. It is emphasized that both embodiments show only the structure of a single switch unit, but the switch unit may very well comprise multiple switches.

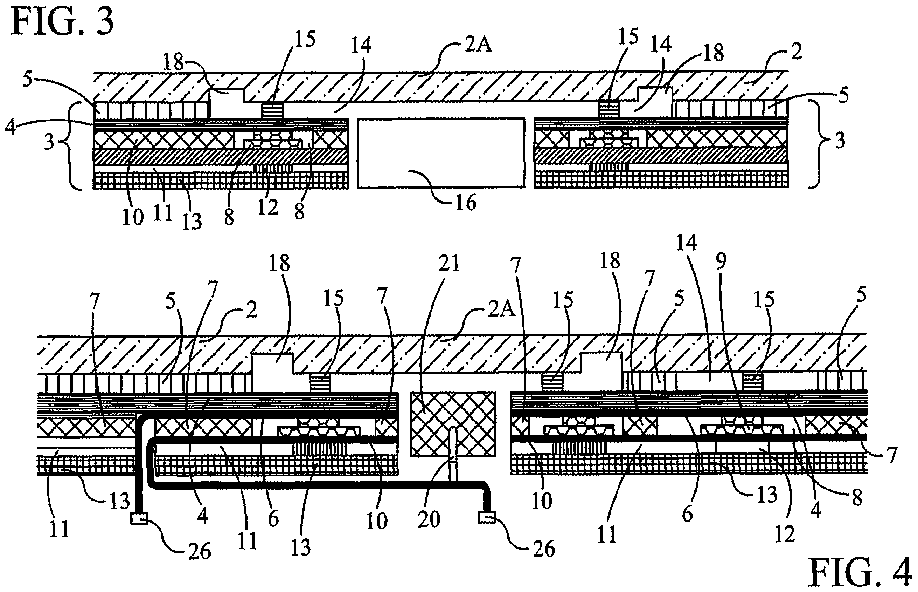

FIG 3 shows a switch unit with a display unit 16 incorporated therein. The structure 3 of the switch unit is substantially the same as that of the preceding embodiments. The piezoelectric elements 9 are laterally located at both sides of the display unit 16, allowing to use the piezoelectric elements 9 as switches to determine not only whether the touch panel being part of the front panel 2 above the display unit 16 has been pressed but also where it has been pressed. This requires the calculating power of a processing unit. Again essential for the embodiment is that the front plate 2 extends beyond the structure 3 with the piezoelectric elements 9 until above the display unit 16 so that seams and other irregularities in the surface are avoided. The actuation area 2a of the front panel 2 above the display unit 16 is transparent. Herein it is noted that the connection between the glue layer 5 and the front plate 2 allows easy flexing of the front plate 2. Also grooves 18 have been provided in the lower side of the front plate 2. Further is it possible that more switches are provided around the display unit making the determination of the location where the touch panel has been pressed easier. It is however also possible that simple switches are provided in combination with the switches forming part of the touch panel.

FIG 4 shows another embodiment wherein the switch unit is combined with a light emitting unit formed by a led 20, arranged in a transparent block 21. Just as in the embodiment according to FIG 3, the front panel 2 extends beyond the actual switch unit over the led. The actuation area 2a of the front panel 2 at the location of the led 20 is transparent to some extend so that the light emitted by the led 20 is visible. Expressed otherwise the led 20 is located in an opening of the switch unit. Herein the two switches serve to determine whether the actuation area 2a of the front plate 2 at the location of the led 20 has been pressed and not so much where it has been pressed. This allows less calculating power of the processing unit. The led 20 is then used to indicate the position of the function controlled by the switches. This configuration allows to arrange a light source at the apparent position of the switch, so that the user gets the impression to press on the light source.

Further this FIG shows an extra 'normal' switch, showing that the switches of several different types may be combined. This combination is also possible with switches and touch panels of the types referred to above to obtain a control panel for electrical appliances, etc. All these switches may use the same structure for the layers to that all layers are common for the switches, leading to substantial savings in the production costs.

It is attractive to use foils for the first and second connection layers 6, 10. The use of these flexible insulating foils with conducting tracks printed thereon allows the use of these foils also for further connection with processing units or power supply. In FIG 4 it is shown that the connection layers 6 and 10 are guided through an aperture 25 in the underlying layers 11 and 13. The foil of the first connection layer 6 is at its end provided of a connector 26 adapted make a connection with a processor or a power supply. The foil of the second connection 10 layer is folded over and adhered to the underside of the led 20. This foil contains tracks leading to the led 20, so that this foil is not only adapted to be used for the power supply and control of the leds 20. This structure may also be used for at least a part of the power supply and control of the display unit 16 in the preceding embodiment. Also this foil ends in a connector 26.

Numerous amendments may be made to the embodiment depicted and described here, wherein the features of different embodiments may be combined while the invention is solely defined by the appended claims.

## Claims

1. A switch unit (1) comprising:
a flat front plate (2), comprising an actuation area (2a);
a structure (3) located behind the front plate (2) adjacent to the actuation area (2a);
at least two pressure sensitive piezoelectric transducers (9) adapted to convert pressure exerted by the front plate (2) to the transducers (9) into electrical signals, the transducers (9) located in the structure (3), in which each of the transducers (9) is located in a first aperture (8) in a transducer layer (7) extending parallel to the front plate (2) between two flexible connection layers (6, 10), the two flexible connection layers (6, 10) being the same for all transducers (9), while each transducer (9) being co-located with a second aperture (14) formed by a neighbouring layer (4) and a glue layer (5) in front or behind the location of the transducer (9);
a processing unit adapted to process the signals from said at least two transducers (9) and to determine whether the actuation area (2a) of the front plate (2) was actuated;
wherein the front plate (2) extends beyond the structure (3) in which the transducers (9) are incorporated; wherein: in the second aperture (14) a distance block (15) is arranged;
wherein: each transducer (9) is further co-located with a third aperture (12) arranged in a neighbouring layer (11) in front or behind the two flexible connection layers (6, 7, 10) and wherein the second and the third apertures are located on opposite sides of the pressure sensitive piezoelectric transducer (9).

2. The switch unit (1) according to any one of the preceding claims, wherein: the front plate (2) is dimensioned to extend over a full face of a device of which the switch unit forms a part.

3. The switch unit (1) according to any one of the preceding claims, wherein: the processing unit is adapted to determine the location within the actuation area where the front panel was actuated.

4. The switch unit (1) according to claim 3, wherein: the front plate (2) at the location of the actuation area (2a) is transparent and that a display device (16) has been located behind the transparent area.

5. The switch unit (1) according to any one of the preceding claims, wherein: the front plate (2) at the location of the actuation area (2a) is transparent and that a light emitting device (20) has been located behind said transparent area.

6. The switch unit (1) according to any one of the preceding claims, wherein: the structure (3) comprises a connection element extending along the circumference of the front plate and forming a connection between the front plate (2) and a rigid part of the structure.

7. The switch unit (1) according to any one of the preceding claims, wherein: a weakening extends around the outer circumference of the combination of the actuation area (2a) and the transducers (9) arranged adjacent to it.

8. The switch unit (1) according to claim 7, wherein: the weakening takes the shape of a groove extending along the underside of the front plate (2).

9. The switch unit (1) according to any one of the preceding claims, wherein: the front plate (2) is partially covered by a cover plate.

10. The switch unit (1) according to claim 1, wherein: the front plate (2) also comprises at least one second actuation area, being transparent and that a light emitting device (20) has been located behind said transparent area.

11. The switch unit (1) according to any one of the preceding claims, wherein: the two flexible connection layers (6, 10) are each composed of a foil comprising conducting tracks connecting each of the transducers (9) to the processing unit.

12. The switch unit (1) as claimed in claim 1, wherein: the processing unit is adapted to process the signals form a number of transducers (9) directly.

13. A device comprising a switch unit (1) according to any one of the preceding claims.

## Patentansprüche

1. Schalteinheit (1), umfassend:
eine flache Frontplatte (2), die einen Betätigungsbereich (2a) umfasst; eine Struktur (3), die hinter der Frontplatte (2) benachbart zum Betätigungsbereich (2a) angeordnet ist;
mindestens zwei druckempfindliche piezoelektrische Wandler (9), die angepasst sind, Druck, der von der Frontplatte (2) auf die Wandler (9) ausgeübt wird, in elektrische Signale umzuwandeln, wobei die Wandler (9) in der Struktur (3) angeordnet sind, wobei jeder der Wandler (9) in einer ersten Öffnung (8) in einer Wandlerschicht (7) angeordnet ist, die sich parallel zur Frontplatte (2) zwischen zwei flexiblen Verbindungsschichten (6, 10) erstreckt, wobei die zwei flexiblen Verbindungsschichten (6, 10) für alle Wandler (9) gleich sind, während jeder Wandler (9) gemeinsam mit einer zweiten Öffnung (14), die durch eine benachbarte Schicht (4) und eine Klebeschicht (5) vor oder hinter der Position des Wandlers (9) gebildet ist, angeordnet ist;
eine Verarbeitungseinheit, die angepasst ist, die Signale von den mindestens zwei Wandlern (9) zu verarbeiten und zu bestimmen, ob der Betätigungsbereich (2a) der Frontplatte (2) betätigt wurde;
wobei sich die Frontplatte (2) über die Struktur (3) hinaus erstreckt, in die die Wandler (9) eingebaut sind;
wobei: in der zweiten Öffnung (14) ein Abstandsstück (15) angeordnet ist;
wobei: jeder Wandler (9) ferner gemeinsam mit einer dritten Öffnung (12) angeordnet ist, die in einer benachbarten Schicht (11) vor oder hinter den beiden flexiblen Verbindungsschichten (6, 7, 10) angeordnet ist, und wobei die zweite und die dritte Öffnung auf gegenüberliegenden Seiten des druckempfindlichen piezoelektrischen Wandlers (9) angeordnet sind.

2. Schalteinheit (1) nach einem der vorhergehenden Ansprüche, wobei: die Frontplatte (2) so bemessen ist, dass sie sich über eine gesamte Fläche einer Vorrichtung erstreckt, von der die Schalteinheit einen Teil bildet.

3. Schalteinheit (1) nach einem der vorhergehenden Ansprüche, wobei: die Verarbeitungseinheit angepasst ist, die Stelle innerhalb des Betätigungsbereich, an der die Frontplatte betätigt wurde, zu bestimmen.

4. Schalteinheit (1) nach Anspruch 3, wobei: die Frontplatte (2) an der Stelle des Betätigungsbereichs (2a) transparent ist und hinter dem transparenten Bereich eine Anzeigevorrichtung (16) angeordnet ist.

5. Schalteinheit (1) nach einem der vorhergehenden Ansprüche, wobei: die Frontplatte (2) an der Stelle des Betätigungsbereichs (2a) transparent ist und hinter dem transparenten Bereich eine lichtemittierende Vorrichtung (20) angeordnet ist.

6. Schalteinheit (1) nach einem der vorhergehenden Ansprüche, wobei: die Struktur (3) ein Verbindungselement umfasst, das sich entlang des Umfangs der Frontplatte erstreckt und eine Verbindung zwischen der Frontplatte (2) und einem starren Teil der Struktur bildet.

7. Schalteinheit (1) nach einem der vorhergehenden Ansprüche, wobei: sich eine Schwächung um den Außenumfang der Kombination aus dem Betätigungsbereich (2a) und den Wandlern (9), die dazu benachbart angeordnet sind, erstreckt.

8. Schalteinheit (1) nach Anspruch 7, wobei: die Schwächung die Form einer Nut annimmt, die sich entlang der Unterseite der Frontplatte (2) erstreckt.

9. Schalteinheit (1) nach einem der vorhergehenden Ansprüche, wobei: die Frontplatte (2) teilweise durch eine Deckplatte bedeckt ist.

10. Schalteinheit (1) nach Anspruch 1, wobei: die Frontplatte (2) zudem mindestens einen zweiten Betätigungsbereich umfasst, der transparent ist und wobei hinter dem transparenten Bereich eine lichtemittierende Vorrichtung (20) angeordnet ist.

11. Schalteinheit (1) nach einem der vorhergehenden Ansprüche, wobei: die beiden flexiblen Verbindungsschichten (6, 10) jeweils aus einer Folie hergestellt sind, die Leiterbahnen umfasst, die jeden der Wandler (9) mit der Verarbeitungseinheit verbinden.

12. Schalteinheit (1) nach Anspruch 1, wobei: die Verarbeitungseinheit angepasst ist, die Signale von einer Reihe von Wandlern (9) direkt zu verarbeiten.

13. Vorrichtung, die eine Schalteinheit (1) nach einem der vorhergehenden Ansprüche umfasst.

## Revendications

1. Unité de commutation (1) comprenant :
une plaque avant plate (2), comprenant une zone d'actionnement (2a) ;
une structure (3) située derrière la plaque avant (2) adjacente à la zone d'actionnement (2a) ;
au moins deux transducteurs piézoélectriques sensibles à la pression (9) adaptés pour convertir une pression exercée par la plaque avant (2) sur les transducteurs (9) en signaux électriques, les transducteurs (9) situés dans la structure (3), chacun des transducteurs (9) étant situé dans une première ouverture (8) dans une couche de transducteur (7) s'étendant parallèlement à la plaque avant (2) entre deux couches de connexion flexibles (6, 10), les deux couches de connexion flexibles (6, 10) étant identiques pour tous les transducteurs (9), chaque transducteur (9) étant co-installé avec une deuxième ouverture (14) formée par une couche voisine (4) et une couche de colle (5) devant ou derrière l'emplacement du transducteur (9) ;
une unité de traitement adaptée pour traiter les signaux provenant desdits au moins deux transducteurs (9) et pour déterminer si la zone d'actionnement (2a) de la plaque avant (2) a été actionnée ;
dans laquelle la plaque avant (2) s'étend au-delà de la structure (3) dans laquelle les transducteurs (9) sont incorporés ;
dans laquelle : dans la deuxième ouverture (14), un bloc de distance (15) est agencé ;
dans laquelle : chaque transducteur (9) est en outre co-installé avec une troisième ouverture (12) agencée dans une couche voisine (11) devant ou derrière les deux couches de connexion flexibles (6, 7, 10) et
dans laquelle les deuxième et troisième ouvertures sont installées sur des côtés opposés du transducteur piézoélectrique sensible à la pression (9).

2. Unité de commutation (1) selon l'une quelconque des revendications précédentes, dans laquelle : la plaque avant (2) est dimensionnée pour s'étendre sur toute une face d'un dispositif dont l'unité de commutation fait partie.

3. Unité de commutation (1) selon l'une quelconque des revendications précédentes, dans laquelle : l'unité de traitement est adaptée pour déterminer l'emplacement dans la zone d'actionnement où le panneau avant a été actionné.

4. Unité de commutation (1) selon la revendication 3, dans laquelle : la plaque avant (2) située à l'emplacement de la zone d'actionnement (2a) est transparente et un dispositif d'affichage (16) a été installé derrière la zone transparente.

5. Unité de commutation (1) selon l'une quelconque des revendications précédentes, dans laquelle : la plaque avant (2) au niveau de l'emplacement de la zone d'actionnement (2a) est transparente, et un dispositif électroluminescent (20) a été installé derrière ladite zone transparente.

6. Unité de commutation (1) selon l'une quelconque des revendications précédentes, dans laquelle : la structure (3) comprend un élément de connexion s'étendant le long de la circonférence de la plaque avant et formant une connexion entre la plaque avant (2) et une partie rigide de la structure.

7. Unité de commutation (1) selon l'une quelconque des revendications précédentes, dans laquelle : un affaiblissement s'étend autour de la circonférence extérieure de la combinaison de la zone d'actionnement (2a) et des transducteurs (9) agencés de manière adjacente à celle-ci.

8. Unité de commutation (1) selon la revendication 7, dans laquelle : l'affaiblissement prend la forme d'une rainure s'étendant le long de la face inférieure de la plaque avant (2).

9. Unité de commutation (1) selon l'une quelconque des revendications précédentes, dans laquelle : la plaque avant (2) est partiellement recouverte par une plaque de couverture.

10. Unité de commutation (1) selon la revendication 1, dans laquelle : la plaque avant (2) comprend également au moins une seconde zone d'actionnement, qui est transparente, et un dispositif électroluminescent (20) a été installé derrière ladite zone transparente.

11. Unité de commutation (1) selon l'une quelconque des revendications précédentes, dans laquelle : les deux couches de connexion flexibles (6, 10) sont chacune composées d'une feuille comprenant des pistes conductrices reliant chacun des transducteurs (9) à l'unité de traitement.

12. Unité de commutation (1) selon la revendication 1, dans laquelle : l'unité de traitement est adaptée pour traiter directement les signaux provenant d'un certain nombre de transducteurs (9).

13. Dispositif comprenant une unité de commutation (1) selon l'une quelconque des revendications précédentes.
